# EUROPEAN PATENT APPLICATION

(11) **EP 4 741 728 A1**
(43) Date of publication of application: **13.05.2026**
(21) Application number: 25215001.6
(22) Date of filing: 11.11.2025
(51) Int. Cl.: F24F 13/24, G06F 1/18, G06F 1/20, H05K 7/20, G10K 11/168, H05K 5/02, G11B 33/08

(54) **ACOUSTIC ATTENUATION DEVICE FOR TELECOMMUNICATIONS CABINETS**

(30) Priority: 12.11.2024 US 202463719176 P
(71) Applicant: Outdoor Wireless Networks LLC, Richardson, TX 75082 (US)
(72) Inventor: SMAILES, Richard, Richardson, Texas, 75082 (US)
(74) Representative: Meissner Bolte Partnerschaft mbB

(57) **Abstract**

The present application is directed to an acoustic attenuation device adapted for use in a telecommunications cabinet. The device includes a housing, a volume matrix having a main body divided into a plurality of chambers, an aperture plate having a plurality of opening arrangements, each opening arrangement aligned with a respective chamber of the volume matrix, a pressure plate coupled to the housing with the volume matrix and aperture plate secured therebetween, and an acoustically transparent filter held against the pressure plate. The pressure plate and the housing are configured to apply pressure to volume matrix and aperture plate sandwiched therebetween to create a tight seal, and the opening arrangements in combination with a corresponding chamber create a plurality of attenuators configured to match one or more dominant frequencies of one or more cooling fans within the cabinet such that the resonant frequency emanating from each attenuator have substantial phase inversion of the dominant frequencies, thereby cancelling noise emanating from the telecommunications cabinet.

## Description

### Related Application(s)

The present application claims priority to and the benefit of U.S. Provisional Patent Application Serial No. 63/719,176, filed November 12, 2024, the disclosures of which are hereby incorporated by reference as if set forth fully herein.

### Field

The present invention is directed generally to telecommunications equipment, and more particularly, an acoustic attenuation device for use in telecommunications cabinets.

### Background

Noise complaints about telecommunications cabinets placed close to residential areas are becoming more commonplace. Most of the noise coming from the telecommunications cabinets is generated by the cooling fans on the cabinet and/or the equipment (e.g., servers) housed within the main compartment of the cabinet. Air movement through the cabinet and ventilation openings (e.g., from cooling fans) generate white noise. The walls of the cabinet act as a resonating chamber which amplifies critical frequencies. The noise generated by the equipment and cabinet cooling fan blades has a frequency profile that emits a specific narrow band fundamental frequency with fifth and octave harmonics. The frequency spikes of the frequency profile for the cooling fans reside within the 1kHz to 4kHz range, which is the most sensitive frequency range of human hearing, and thus, the noise coming from the telecommunications cabinet is perceived as being louder and more disturbing. Typically, telecommunications cabinets use a negative pressure arrangement in which air is drawn in through louvres coupled with a filter in the cabinet door and the cabinet cooling fan(s) is housed in a void area in the roof of the cabinet and exhausted through a labyrinth of vents at the front and rear of roof. Current attempts to solve noise issues surrounding telecommunications cabinets include the application of noise deadening foam on the inner walls of the main compartment. Alternative ways to mitigate noise the heard from a telecommunications cabinet may be desired.

### Summary

A first aspect of the present invention is directed to an acoustic attenuation device adapted for use in a telecommunications cabinet. The acoustic attenuation device includes a housing having a cavity and a volume matrix sealed within the cavity of the housing. The volume matrix has a main body divided into a plurality of chambers. The device further includes an aperture plate engaged with the volume matrix. The aperture plate has a plurality of opening arrangements, each opening arrangement aligned with a respective chamber of the volume matrix. The device further includes pressure plate coupled to the housing with the volume matrix and aperture plate secured therebetween. The pressure plate has a plurality of openings, each opening aligned with a respective opening arrangement in the aperture plate. The device also includes an acoustically transparent filter held against the pressure plate. The pressure plate and the housing are configured to apply pressure to volume matrix and aperture plate sandwiched therebetween to create a tight seal. The opening arrangements of the aperture plate, in combination with a corresponding chamber of the volume matrix, create a plurality of attenuators configured to match one or more dominant frequencies of one or more cooling fans within the telecommunications cabinet such that the resonant frequency emanating from each attenuator have substantial phase inversion of the one or more dominant frequencies, thereby cancelling noise emanating from the telecommunications cabinet.

In some embodiments, at least one of the one or more cooling fans are part of a server, and the device has compact size, thereby allowing the device to be fixed to an internal surface of the telecommunications cabinet in close proximity to server cooling fan while occupying minimal cabinet space.

In some embodiments, the acoustic attenuation device further includes an upper cap plate and a lower support plate, the upper cap plate and lower support plate are configured to engage with the pressure plate to secure the filter in place.

In some embodiments, the housing further includes four side walls extending outwardly from a backing plate, the backing plate and side walls together define the cavity configured to receive and hold the volume matrix therein.

In some embodiments, the housing further includes two flanged edges extending outwardly from opposing side walls, each flanged edge includes a plurality of apertures configured to receive a respective fastener to secure the pressure plate thereto and/or to mount and secure the acoustic attenuation device to an interior surface of the telecommunications cabinet.

In some embodiments, the plurality of chambers are arranged in a grid configuration in the main body of the volume matrix.

In some embodiments, the plurality of chambers are arranged in a series of rows and columns in the main body of the volume matrix.

In some embodiments, the volume matrix is formed from glass reinforced plastic and the aperture plate is formed from aluminum.

In some embodiments, the plurality of opening arrangements of the aperture plate have openings including a single oblong opening, two circular openings in a stacked arrangement, three circular openings in a triangular arrangement, and/or four circular openings in a square arrangement, and the plurality of opening arrangements together achieve a resonant frequency needed to match the dominant frequencies of the cooling fans within the telecommunications cabinet.

In some embodiments, the pressure plate further includes an upper wall, a lower wall, and two opposing side walls extending outwardly from a main plate, the upper and lower walls extend outwardly from the main plate in a first direction and are configured to engage with the housing and the opposing side walls extend outwardly from the main plate in a second opposing direction and are configured to engage with and provide a mounting location for the filter.

In some embodiments, the pressure plate further includes two flanged edges extending outwardly from the upper and lower walls, each flanged edge includes a plurality of apertures configured to receive a respective fastener to secure the pressure plate to the housing, the fasteners are configured to pull the pressure plate and housing toward each other and apply pressure to the volume matrix and aperture plate sandwiched therebetween, thereby creating a tight seal.

In some embodiments, the opposing side walls include one or more apertures configured to receive a respective fastener to secure the upper cap plate and/or lower support plate to the pressure plate.

In some embodiments, the opposing side walls further include a lip extending inwardly therefrom, and the lip of each opposing side wall, the upper cap plate, and the lower support plate together are configured to hold and secure the filter against the pressure plate.

In some embodiments, the upper cap plate includes a main body having a flanged edge extending longitudinally and downwardly therefrom and arm members extending downwardly from opposing ends of the main body, and each arm member is configured to secure the upper cap plate to the pressure plate and the flanged edge configured to hold and secure the filter against the pressure plate.

In some embodiments, the lower support plate includes a main body having a flanged edge extending longitudinally and upwardly therefrom and arm members extending upwardly from opposing ends of the main body, and each arm member is configured to secure the lower support plate to the pressure plate and the flanged edge is configured to hold and secure the filter against the pressure plate.

In some embodiments, the filter includes an open cell, acoustically transparent form.

In some embodiments, the filter is configured to act as an absorber to help increase the frequency bandwidth from each individual attenuator.

Another aspect of the present invention is directed to an acoustic attenuation device adapted for use in a telecommunications cabinet containing at least one cooling fan having one or more dominant frequencies emanating therefrom. The acoustic attenuation device includes a housing having a cavity, a volume matrix sealed within the cavity of the housing and having a main body divided into a plurality of chambers arranged in a series of rows and columns, and an aperture plate engaged with the volume matrix. The aperture plate includes a plurality of opening arrangements, each opening arrangement aligned with a respective chamber of the volume matrix and together are configured to achieve a resonant frequency that match the one or more dominant frequencies of the at least one cooling fan within the telecommunications cabinet. The acoustic attenuation device further includes a pressure plate coupled to the housing with the volume matrix and aperture plate secured therebetween. The pressure plate has a plurality of openings, each opening aligned with a respective opening arrangement in the aperture plate. The acoustic attenuation device also includes an acoustically transparent filter held against the pressure plate.

In some embodiments, the pressure plate and the housing are configured to apply pressure to volume matrix and aperture plate sandwiched therebetween to create a tight seal, and the opening arrangements of the aperture plate in combination with the corresponding chamber of the volume matrix create a plurality of attenuators configured to match the one or more dominant frequencies of the at least one cooling fan such that the resonant frequency emanating from each attenuator have substantial phase inversion of the dominant frequencies, thereby cancelling noise emanating from the telecommunications cabinet.

In some embodiments, the acoustic attenuation device further includes an upper cap plate and a lower support plate, the upper cap plate and lower support plate configured to engage with the pressure plate to secure the filter in place.

In some embodiments, the housing further includes four side walls extending outwardly from a backing plate, the backing plate and side walls together define the cavity configured to receive and hold the volume matrix therein.

In some embodiments, the volume matrix is formed from glass reinforced plastic and the aperture plate is formed from aluminum.

In some embodiments, the plurality of opening arrangements of the aperture plate have openings including a single oblong opening, two circular openings in a stacked arrangement, three circular openings in a triangular arrangement, and/or four circular openings in a square arrangement, and the plurality of opening arrangements together achieve a resonant frequency needed to match the dominant frequencies of the cooling fans within the telecommunications cabinet.

In some embodiments, the pressure plate further includes an upper wall, a lower wall, and two opposing side walls extending outwardly from a main plate, the upper and lower walls extend outwardly from the main plate in a first direction and are configured to engage with the housing and the opposing side walls extend outwardly from the main plate in a second opposing direction and are configured to engage with and provide a mounting location for the filter.

In some embodiments, the opposing side walls include one or more apertures configured to receive a respective fastener to secure the upper cap plate and lower support plate to the pressure plate.

In some embodiments, the opposing side walls further include a lip extending inwardly therefrom, and the lip of each opposing side wall, the upper cap plate, and the lower support plate together are configured to hold and secure the filter against the pressure plate.

In some embodiments, the filter includes an open cell, acoustically transparent form, and the filter is configured to act as an absorber to help increase the frequency bandwidth from each individual attenuator.

Another aspect of the present invention is directed to a telecommunications cabinet. The telecommunications cabinet includes a floor, a roof, a rear wall, opposing side walls, and a door which together define an internal cavity having one or more cooling fans therein. The telecommunications cabinet further includes an acoustic attenuation device mounted within the internal cavity. The one or more cooling fans produce noise at one or more dominant frequencies, and the acoustic attenuation device is configured to produce a resonant frequency that matches the one or more dominant frequencies such that the resonant frequency emanating from the acoustic attenuation device has substantial phase inversion of the one or more dominant frequencies, thereby cancelling noise emanating from the one or more cooling fans.

In some embodiments, the at least one acoustic attenuation device is mounted to an interior surface of the door.

In some embodiments, the at least one acoustic attenuation device is mounted within a void in the roof.

In some embodiments, the at least one acoustic attenuation device includes a housing having a cavity, a volume matrix sealed within the cavity of the housing, the volume matrix including a main body divided into a plurality of chambers, an aperture plate engaged with the volume matrix, the aperture plate including a plurality of opening arrangements, each opening arrangement aligned with a respective chamber of the volume matrix, a pressure plate coupled to the housing with the volume matrix and aperture plate secured therebetween, the pressure plate including a plurality of openings, each opening aligned with a respective opening arrangement in the aperture plate, and an acoustically transparent filter held against the pressure plate.

In some embodiments, the pressure plate and the housing of the acoustic attenuation device are configured to apply pressure to volume matrix and aperture plate sandwiched therebetween to create a tight seal, and the opening arrangements of the aperture plate in combination with the corresponding chamber of the volume matrix create a plurality of attenuators configured to match the one or more dominant frequencies of one or more cooling fans within the telecommunications cabinet.

In some embodiments, at least one cooling fan resides within a void in the roof and at least one cooling fan is part of a server within the internal cavity, and an acoustic attenuation device is mounted in the void in the roof and an acoustic attenuation device is mounted to an interior surface of the door.

It is noted that aspects of the invention described with respect to one embodiment, may be incorporated in a different embodiment although not specifically described relative thereto. That is, all embodiments and/or features of any embodiment can be combined in any way and/or combination. Applicant reserves the right to change any originally filed claim and/or file any new claim, accordingly, including the right to be able to amend any originally filed claim to depend from and/or incorporate any feature of any other claim or claims although not originally claimed in that manner. These and other objects and/or aspects of the present invention are explained in detail in the specification set forth below. Further features, advantages and details of the present invention will be appreciated by those of ordinary skill in the art from a reading of the figures and the detailed description of the preferred embodiments that follow, such description being merely illustrative of the present invention.

### Brief Description of the Figures

**FIG. 1A** is a top perspective view of an acoustic attenuation device according to embodiments of the present invention.
**FIG. 1B** is a side view of the acoustic attenuation device of **FIG. 1A****.**
**FIG. 1C** is a front view of the acoustic attenuation device of **FIG. 1A****.**
**FIG. 1D** is a rear view of the acoustic attenuation device of **FIG. 1A****.**
**FIG. 2** is an exploded perspective view of the acoustic attenuation device of **FIGS. 1A-1D****.**
**FIG. 3A** is a front perspective view of a housing of the acoustic attenuation device of **FIG. 1A** according to embodiments of the present invention.
**FIG. 3B** is a rear perspective view of the housing of **FIG. 3A****.**
**FIG. 4A** is a perspective view of a volume matrix of the acoustic attenuation device of **FIG. 1A** according to embodiments of the present invention.
**FIG. 4B** is a front view of the volume matrix of **FIG. 4A****.**
**FIG. 4C** is a side view of the volume matrix of **FIG. 4A****.**
**FIG. 4D** is a front perspective view illustrating the volume matrix of **FIG. 4A** held within the cavity of the housing pf **FIG. 3A****.**
**FIG. 5A** is a front perspective view of an aperture plate of the acoustic attenuation device of **FIG. 1A** according to embodiments of the present invention.
**FIG. 5B** is a front view of the aperture plate of **FIG. 5A****.**
**FIG. 5C** is a side view of the aperture plate of **FIG. 5A****.**
**FIG. 5D** is a rear view illustrating the aperture plate of **FIG. 5A** sealed (*e.g*., via adhesive or gasket) to the volume matrix of **FIG. 4A** according to embodiments of the present invention.
**FIGS. 6A-6E** illustrate additional exemplary opening arrangements that may be used in the aperture plate of **FIGS. 5A-5C** according to embodiments of the present invention.
**FIG. 7A** is a front perspective view of a pressure plate of the acoustic attenuation device of **FIG. 1A** according to embodiments of the present invention.
**FIG. 7B** is a rear perspective view of the pressure plate of **FIG. 7A****.**
**FIG. 7C** is a front view illustrating the pressure plate secured against the aperture plate.
**FIG. 8A** is a top perspective view of an upper cap plate of the acoustic attenuation device of **FIG. 1A** according to embodiments of the present invention.
**FIG. 8B** is an enlarged partial perspective view of the section labeled "8B" of the acoustic attenuation device in **FIG. 1A** illustrating the engagement of the upper cap plate and the pressure plate to secure the filter.
**FIG. 9A** is a top perspective view of a lower support plate of the acoustic attenuation device of **FIG. 1A** according to embodiments of the present invention.
**FIG. 9B** is an enlarged partial perspective view of the section labeled "6F" of the acoustic attenuation device in FIG. **1A** illustrating the engagement of the lower support plate and the pressure plate to secure the filter.
**FIG. 10A** is a front view of a filter of the acoustic attenuation device of **FIG. 1A** according to embodiments of the present invention.
**FIG. 10B** is a side view of the filter of **FIG. 10A****.**
**FIGS. 11A-11E** illustrate the acoustic attenuation device of **FIGS. 1A-1D** installed in an exemplary telecommunications cabinet according to embodiments of the present invention.
**FIGS. 12A-12B** illustrate the acoustic attenuation device of **FIGS. 1A-1D** installed in another exemplary telecommunications cabinet according to embodiments of the present invention.
**FIG. 13A** is a graph illustrating an exemplary noise source frequency spectrum.
**FIG. 13B** is a graph illustrating an exemplary classic Helmholtz resonator frequency response.

### Detailed Description

The present invention is described more fully hereinafter with reference to the accompanying drawings, in which embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art.

In the figures, certain layers, components, or features may be exaggerated for clarity, and broken lines illustrate optional features or operations unless specified otherwise. This invention may, however, be embodied in many different forms and should not be construed as limited to the embodiments set forth herein; rather, these embodiments are provided so that this disclosure will be thorough and complete, and will fully convey the scope of the invention to those skilled in the art.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer, or section. Thus, a first element, component, region, layer, or section discussed below could be termed a second element, component, region, layer or section without departing from the teachings of the present invention. The sequence of operations (or steps) is not limited to the order presented in the claims or figures unless specifically indicated otherwise.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the specification and relevant art and should not be interpreted in an idealized or overly formal sense unless expressly so defined herein. Well-known functions or constructions may not be described in detail for brevity and/or clarity.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items.

As used herein, phrases such as "between X and Y" and "between about X and Y" should be interpreted to include X and Y. As used herein, phrases such as "between about X and Y" mean "between about X and about Y." As used herein, phrases such as "from about X to Y" mean "from about X to about Y."

It will be understood that when an element is referred to as being "on", "attached" to, "connected" to, "coupled" with, "contacting", etc., another element, it can be directly on, attached to, connected to, coupled with or contacting the other element or intervening elements may also be present. In contrast, when an element is referred to as being, for example, "directly on", "directly attached" to, "directly connected" to, "directly coupled" with or "directly contacting" another element, there are no intervening elements present. It will also be appreciated by those of skill in the art that references to a structure or feature that is disposed "adjacent" another feature may have portions that overlap or underlie the adjacent feature.

Spatially relative terms, such as "under", "below", "lower", "over", "upper", "lateral", "left", "right" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is inverted, elements described as "under" or "beneath" other elements or features would then be oriented "over" the other elements or features. The device may be otherwise oriented (rotated 90 degrees or at other orientations) and the descriptors of relative spatial relationships used herein interpreted accordingly.

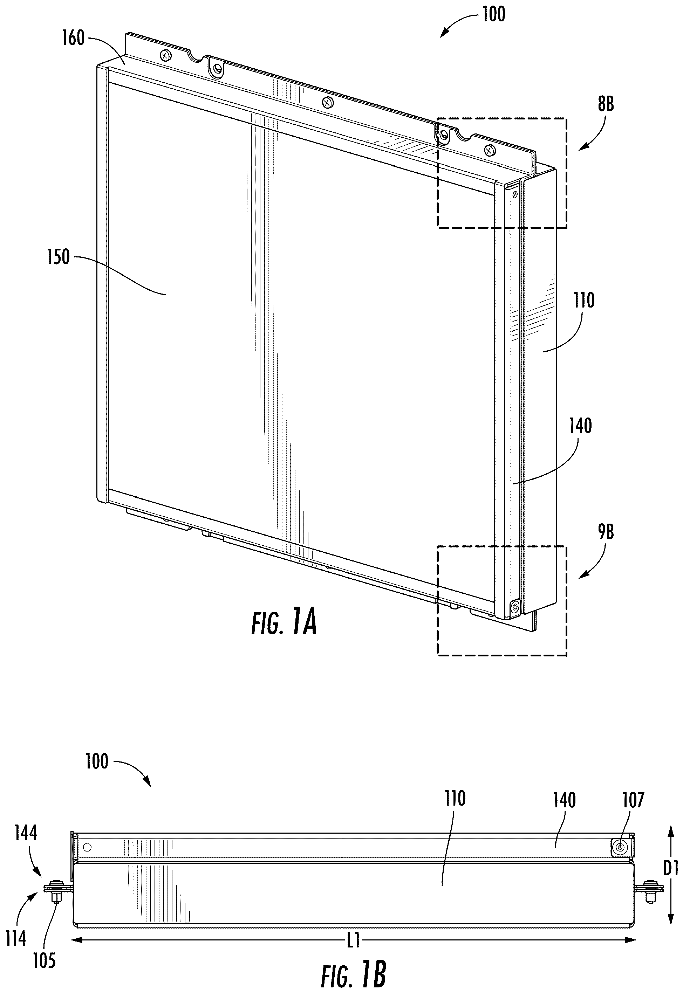

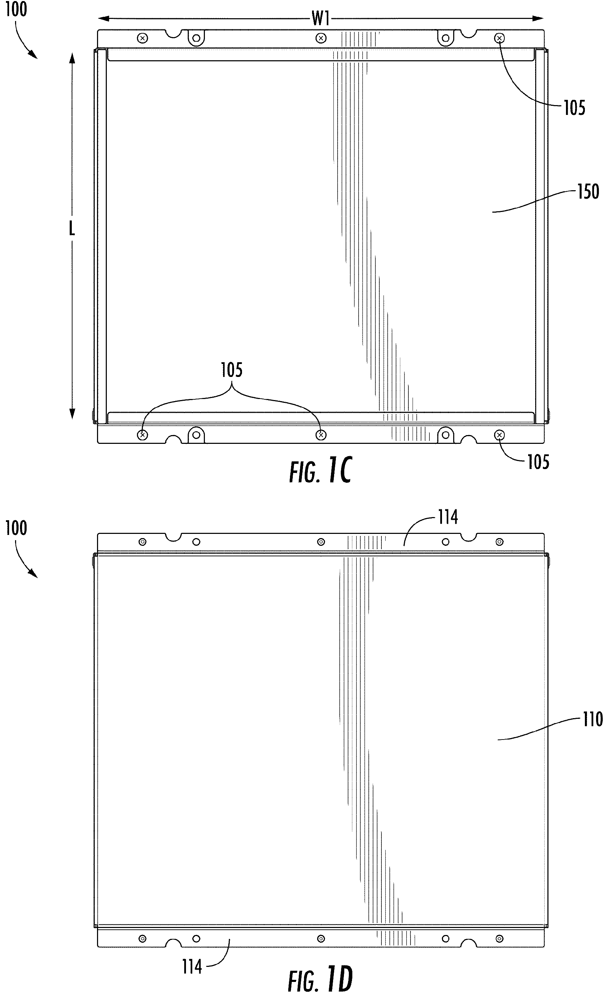

Embodiments of the present invention are directed an acoustic attenuation device for use in telecommunications cabinets. According to embodiments of the present invention, the acoustic attenuation device is configured to match the dominant frequencies (frequency spikes) of the cooling fans within a telecommunications cabinet, thereby reactively cancelling noise generated by the cabinet. Embodiments of the present invention will now be described in further detail below with reference to **FIGS. 1A-13B****.**

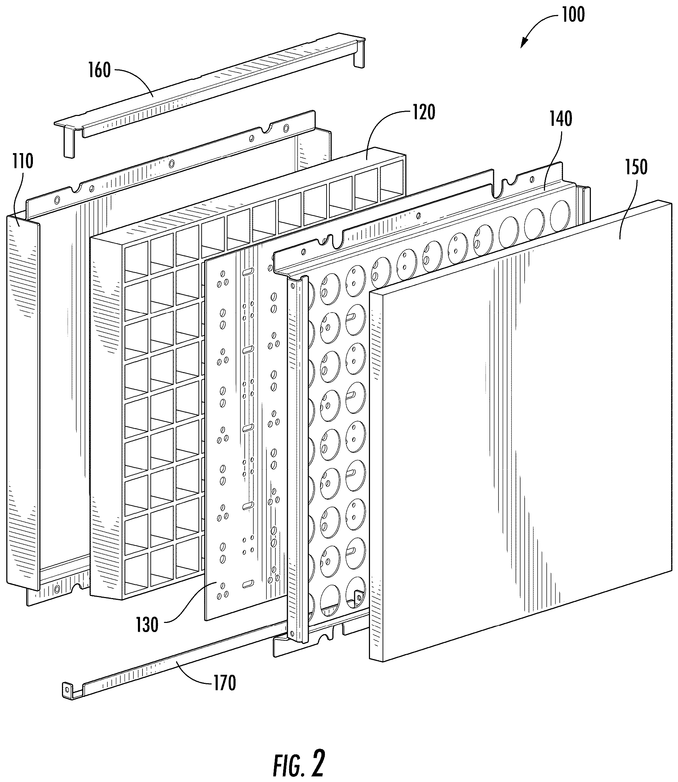

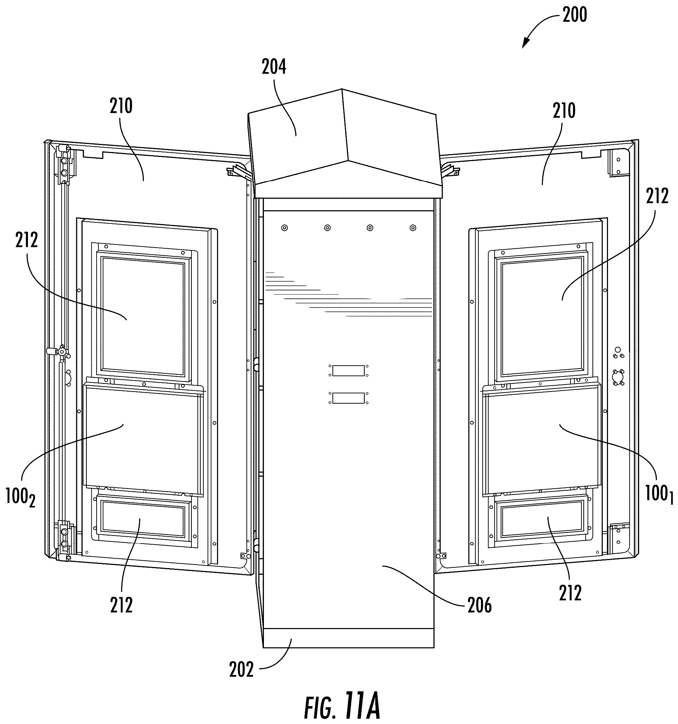

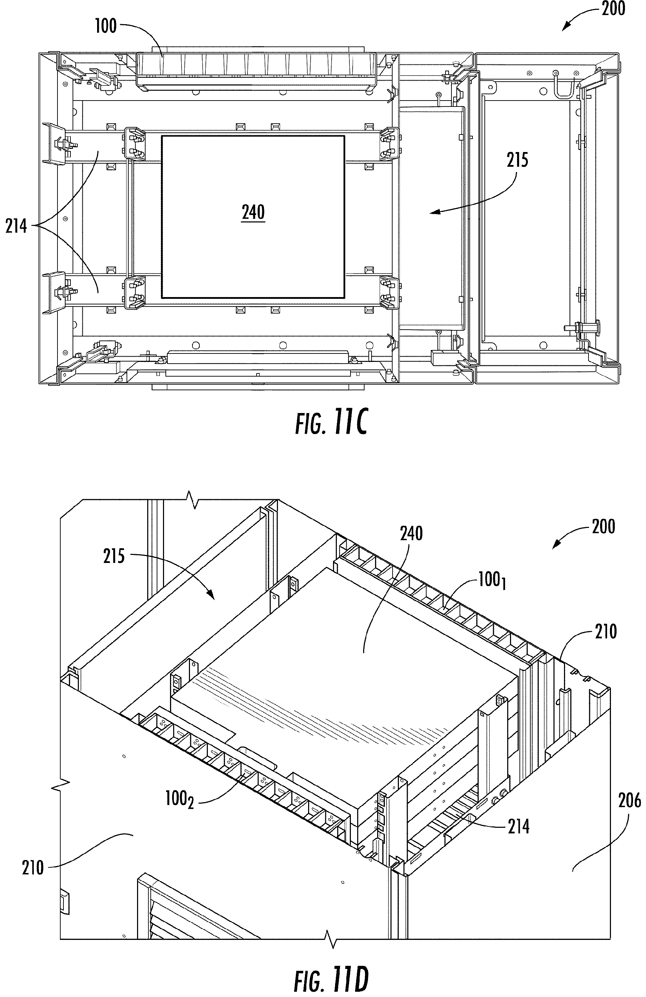

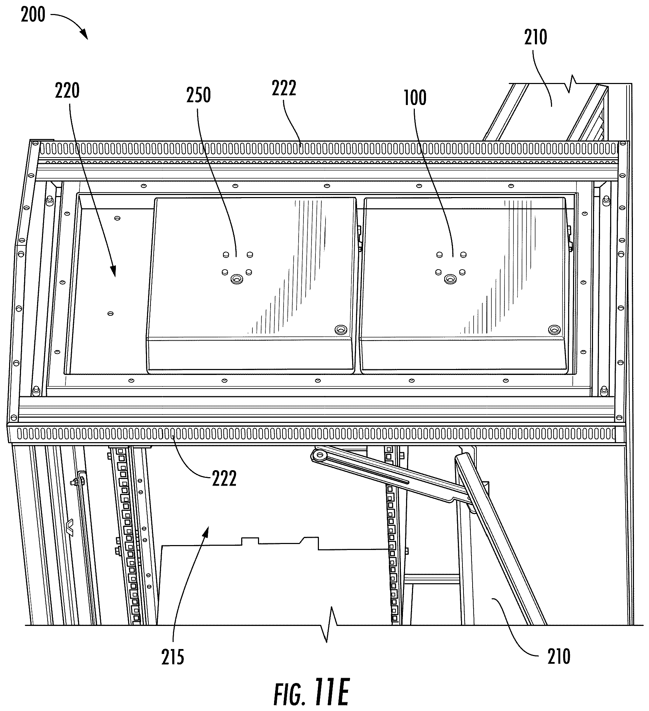

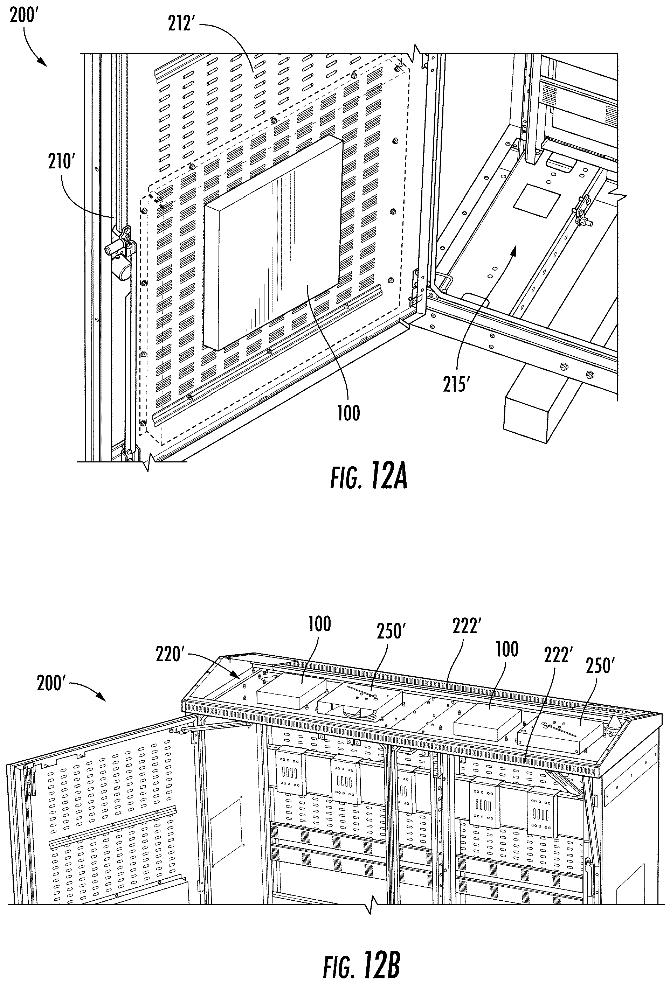

Referring to **FIGS. 1A-1D** and **FIG. 2****,** an acoustic attenuation device **100** adapted for use in a telecommunications cabinet according to embodiments of the present invention, is illustrated. The acoustic attenuation device **100** has a compact length **(L1),** width **(W1),** and depth **(D1)** such that the acoustic attenuation device **100** can easily be installed on an interior surface of a door **210** *(see, e.g.,* **FIGS. 11A-11D** and **FIG. 12A****)** and/or within the roof void **220** *(see, e.g.,* **FIG. 11E** and **FIG. 12B****)** of different types of telecommunications cabinets **200, 200'.** For example, in some embodiments, the acoustic attenuation device **100** may have an overall length **(L1)** in a range of about 53.5 millimeters and about 667 millimeters. In some embodiments, the acoustic attenuation device **100** may have an overall width **(W1)** in a range of about 49.5 millimeters and about 663 millimeters. In some embodiments, the acoustic attenuation device **100** may have an overall depth **(D1)** in a range of about 47 millimeters and about 59.5 millimeters. The compact size allows the acoustic attenuation device **100** to be fixed to the internal surfaces of the cabinet **200, 200',** in close proximity to the noise source while occupying minimal cabinet space *(see, e.g.,* **FIGS. 11C-11E****).**

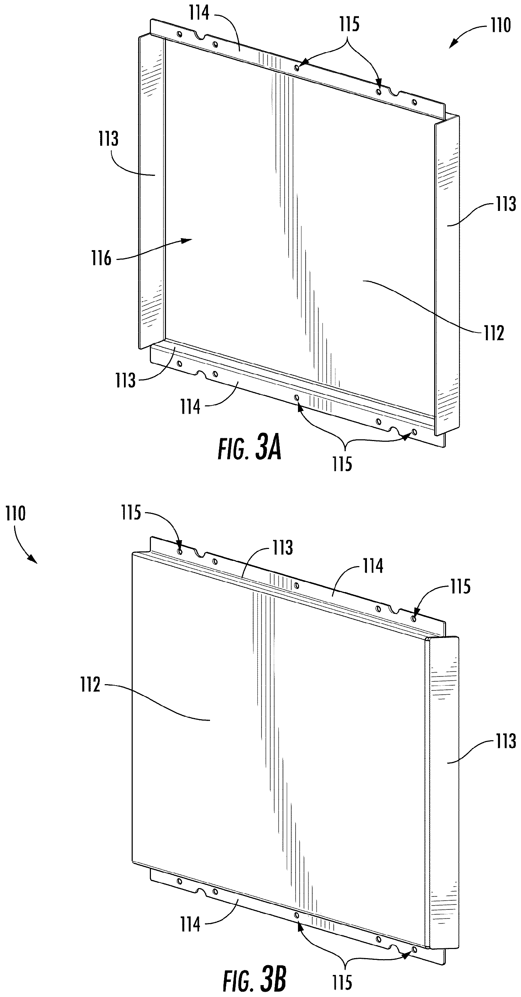

**FIG. 2** illustrates an exploded view of the acoustic attenuation device **100.** As shown in **FIG. 2****,** in some embodiments, the acoustic attenuation device **100** may comprise a housing **110**, a volume matrix **120,** an aperture plate **130,** a pressure plate **140,** and a filter **150.** In some embodiments, the acoustic attenuation device **100** may further comprise an upper cap plate **160** and a lower support plate **170.** Each of these components will be described in further detail below with reference to **FIGS. 3A-3B****,** **FIGS. 4A-4D****,** **FIGS. 5A-5D****,** **FIGS. 7A-7C****,** **FIGS. 8A-****8B,** **FIGS. 9A-9B****,** and **FIGS. 10A-10B****.**

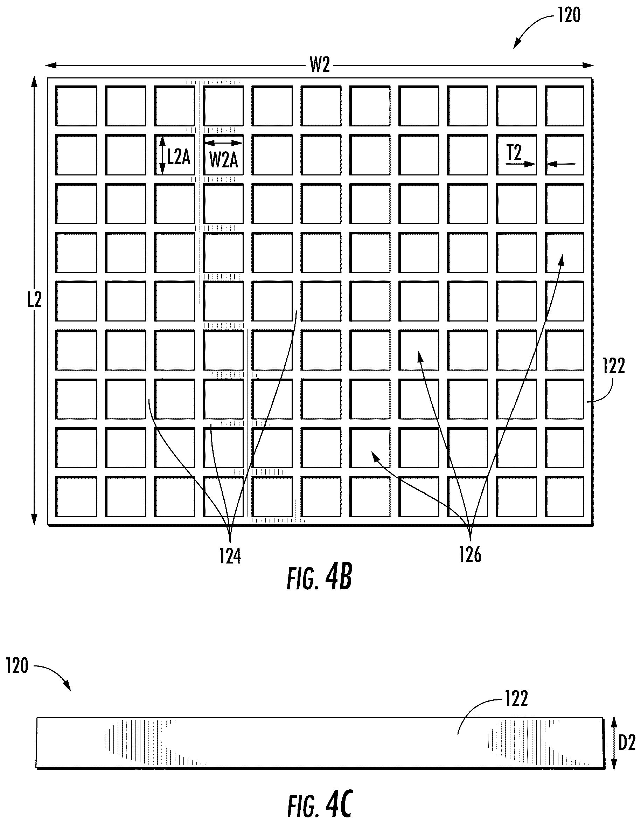

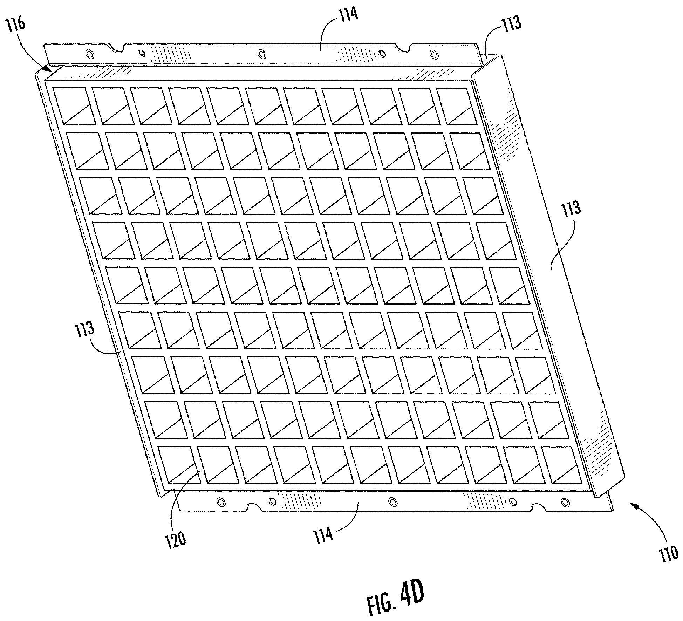

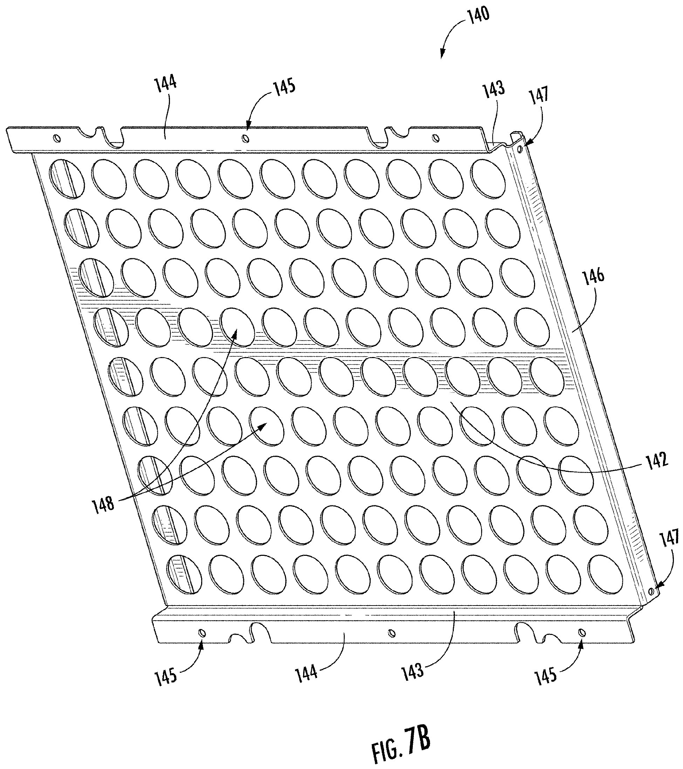

The housing **110** of the acoustic attenuation device **100** is shown in **FIGS. 3A-3B****.** The housing **110** provides a backing plate **112** that is configured to enclose the volume matrix **120.** The housing **110** provides fixing points for the pressure plate **140** and securing of the device **100** within a telecommunications cabinet **200, 200'** *(see, e.g.,* **FIGS. 11A-11E** and **FIGS. 12A-12B****),** while also providing an aesthetic masking of the internal components of the device **100** *(e.g.,* the volume matrix **120** and aperture plate **130).** As shown in **FIGS. 3A-3B****,** in some embodiments, the housing **110** comprises four side walls **113** extending outwardly from the backing plate **112.** The backing plate **112** and side walls **113** together define a cavity **116** configured to receive and hold the volume matrix **120** therein *(see, e.g.,* **FIG. 2** and **FIG. 4D****).** In some embodiments, the housing **110** further comprises two flanged edges **114** extending outwardly from opposing side walls **113.** The flanged edges **114** comprise a plurality of apertures **115.** Some of the apertures **115** in each flanged edge **114** are configured to receive a respective fastener 105 to secure the pressure plate **140** thereto, thereby securing the volume matrix 120 and the aperture plate **130** therebetween *(see, e.g.,* **FIGS. 1B-1C** and **FIG. 7B****).** In some embodiments, some of the apertures **115** in each of the flanged edges **114** are configured to receive a respective fastener **105** to mount and secure the acoustic attenuation device **100** to an interior surface of the telecommunications cabinet **200, 200'** (*see, e.g.,* **FIGS. 11A-11E** and **FIGS. 12A-12B****).**

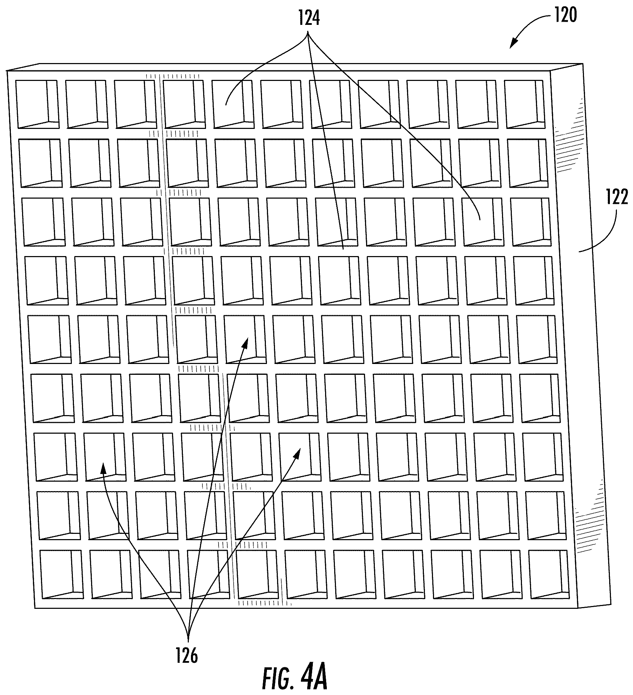

An example volume matrix **120** of the acoustic attenuation device **100** is illustrated in **FIGS. 4A-4D****.** As noted above, and as shown in **FIG. 4D****,** the volume matrix **120** is sized and configured to fit within the cavity **116** of the housing **110**. For example, in some embodiments, the volume matrix **120** may have a length **(L2)** in a range of about 42.5 millimeters and about 656.5 millimeters, a width **(W2)** in a range of about 42.5 millimeters and about 656.5 millimeters, and a depth **(D2)** in a range of about 25 millimeters and about 37.5 millimeters.

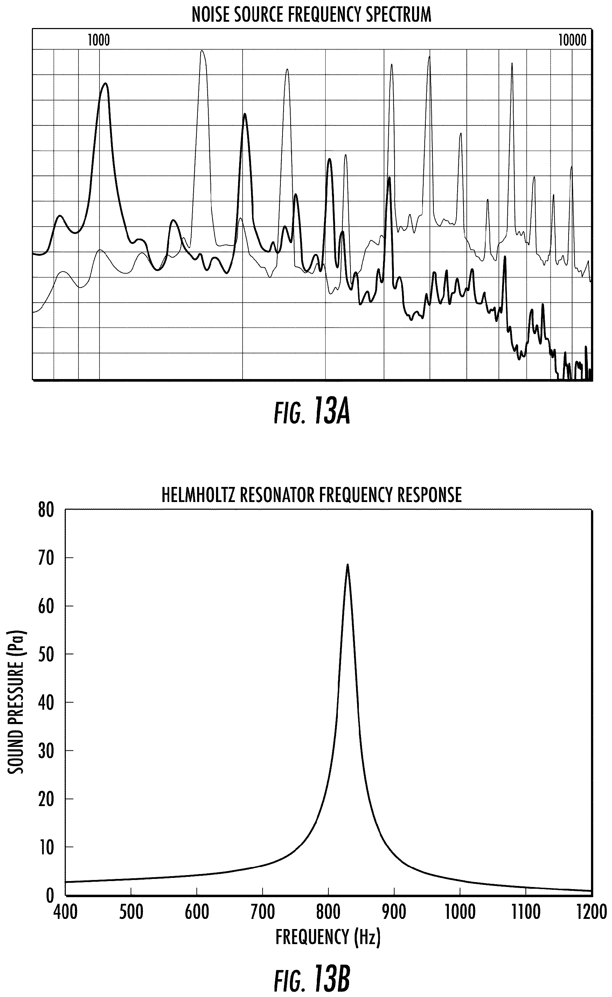

As shown in **FIG. 4A****,** **FIG. 4B** and **FIG. 4D****,** in some embodiments, the volume matrix **120** has a main body **122** having a mesh or grid configuration. In some embodiments, the main body **122** comprises a plurality of inner walls **124** that divide the main body **122** into individual volumes or chambers **126.** As described in further detail below, the individual chambers **126** will help to achieve a Helmholtz resonator-type frequency response within the acoustic attenuation device **100.** A classic Helmholtz resonator consists of two key components: a cavity and a neck. According to embodiments of the present invention, the chambers **126** of the volume matrix **120** may serve as the "cavity" component of a Helmholtz resonator. As shown in **FIG. 4A-4B****,** in some embodiments, each chamber **126** may have a generally square shape and are organized in a series of rows and columns. For example, as shown in **FIG. 4A-4B****,** in some embodiments, the volume matrix **120** may be divided into 99 individual chambers **126** which may be organized into 9 rows and 11 columns (or 11 rows and 9 columns). It is noted that the number of chambers **126** (*e.g*., rows and columns) and their shape and size may vary and is dependent upon the resonant frequency needed to provide sufficient reactive cancelling of the noise generated by the cooling fans based on varying fan duty points (*e.g*., 100%, 80%, 60%, etc.) within the telecommunications cabinet **200**, **200'**. In other words, the high amplitude, narrow frequency peaks *(i.e.,* dominant frequencies) from the noise source are matched by the response of the acoustic attenuation device **100** of the present invention, thereby cancelling the noise emanating from the cabinet **200, 200'** *(see, e.g.,* **FIGS. 13A-13B****).** In some embodiments, each chamber **126** may have a length **(L2A)** in a range of about 33 millimeters and about 31 millimeters and a width **(W2A)** in a range of about 33 millimeters and about 31 millimeters. It is further noted that while each chamber **126** of the volume matrix **120** shown in **FIGS. 4A-4B** has a generally square shape, the individual chambers **126** of the volume matrix **120** may be formed in a variety of different shapes, for example, circular or other polygonal shapes such as hexagonal (*e.g.*, like a honeycomb), octagonal, diamond, rhomboid, etc.

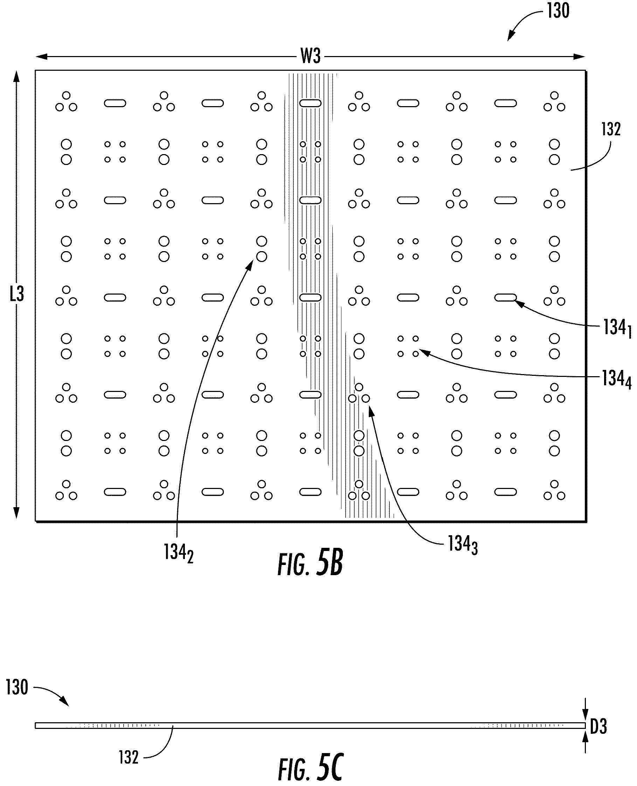

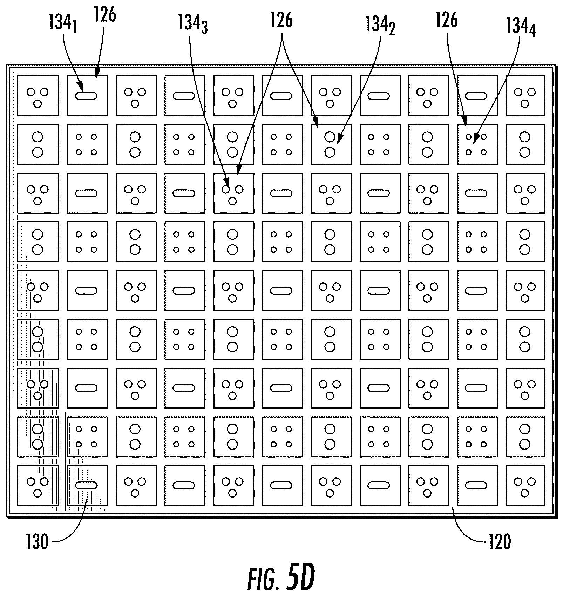

In some embodiments, the volume matrix **120** may be formed from glass reinforced plastic (GRP). According to embodiments of the present invention, the inner walls **124** of the main body **122** have a thickness **(T2)** that provides a sufficient contact surface for sealant to be applied and the GRP material allows for the volume matrix **120** to be easily adhered (*e.g*., glued) or sealed (e*.g.,* with a gasket) to the housing **110** (and the aperture plate **130),** thereby creating properly sealed chambers **126** *(see, e.g.,* **FIG. 5D****).** It is important to have tightly sealed chambers **126** in order to achieve sufficient reactive cancelling of the noise emanating from the telecommunications cabinet **200, 200'.**

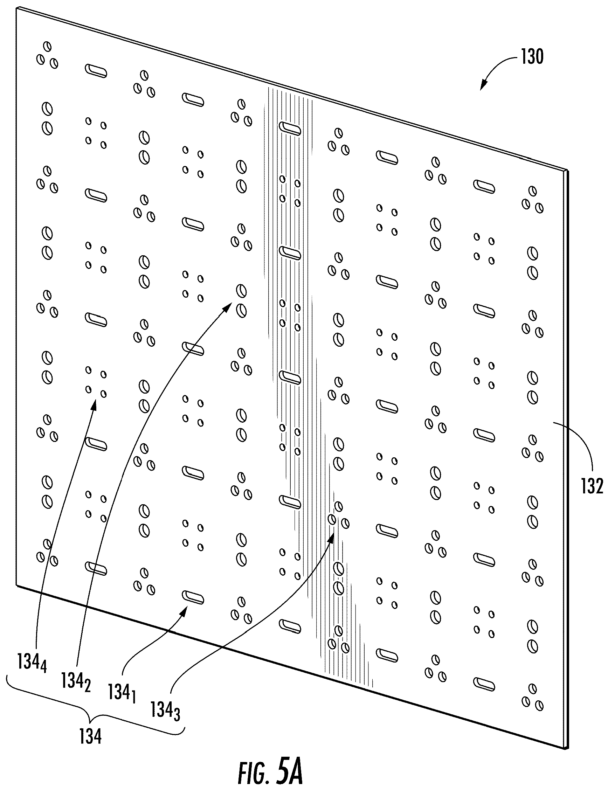

An example aperture plate **130** of the acoustic attenuation device **100** according to embodiments of the present invention is illustrated in **FIGS. 5A-5D****.** The aperture plate **130** has a main body **132** comprising a plurality of openings **134.** The aperture plate **130** is sized and configured engage with the volume matrix **120** and fit within the cavity **116** of the housing **110** *(see, e.g.,* **FIG. 2** and **FIG. 5D****).** For example, in some embodiments, the aperture plate 130 may have a length **(L3)** in a range of about 47.5 millimeters and about 661.5 millimeters, a width **(W3)** in a range of about 47.5 millimeters and about 661.5 millimeters, and a depth (D3) in a range of about 1.5 millimeters and about 5 millimeters.

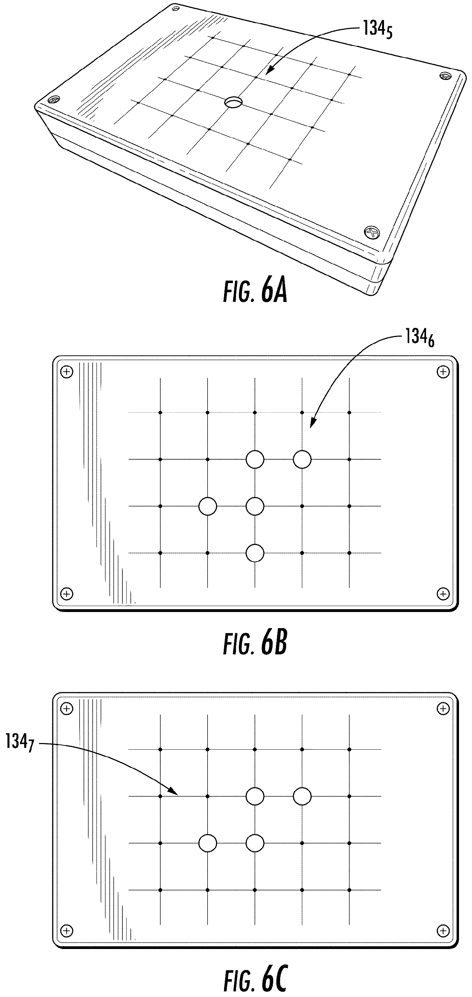

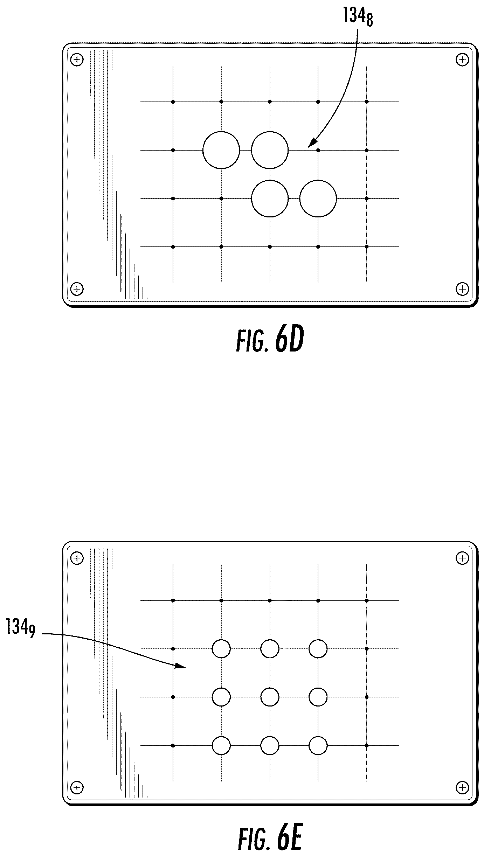

The openings **134** have various shapes and sizes configured *(i.e.,* calibrated) to create resonators that match the different frequency spikes *(i.e.,* dominant frequencies) of the cooling fans based on varying fan duty points (*e.g.,* 100%, 80%, 60%, etc.) within the telecommunications cabinet **200, 200'**. For example, as shown in **FIG. 5A****,** **FIG. 5B****,** and **FIG. 5D****,** in some embodiments, the openings **134** may comprise a single oblong opening **(134₁),** two circular openings in a stacked arrangement **(134₂),** three circular openings in a triangular arrangement (**134₃**), and/or four circular openings in a square arrangement (**134₄**). Additional alternative opening arrangements **134₄₋₉** that may be used in the aperture plate **130** are shown in **FIGS. 6A-6E****.** It is noted that the different configurations or arrangements of the openings **134₁**-**₉** for the aperture plate **130** illustrated in **FIGS. 5A-5B** and **FIGS. 6A-6E** are exemplary, and a variety of different combinations of numbers, sizes, and arrangements or configurations of openings **134** made be used in the aperture plate **130** in order to achieve the appropriate resonance needed to match the dominant frequencies of the cooling fans at different operating output within the telecommunications cabinet **200, 200'**.

As shown in **FIG. 5D****,** each opening arrangement **134** corresponds to a respective chamber **126** of the volume matrix **120,** and may serve as the second ("neck") component of a Helmholtz resonator. Thus, according to embodiments of the present invention, when the openings **134** in the aperture plate **130** are properly calibrated to match the frequency spikes of the cooling fans within the telecommunications cabinet **200**, **200'**, the resonant frequency emanating from each chamber **126** and corresponding openings **134** (*i.e.,* the individual attenuators) will have substantial or complete phase inversion, thereby cancelling the noise from the source (*e.g*., the cooling fan blades).

In general, the noise profile of the cooling fans comprise distinct narrow peaks and random noise. The spectrum frequency and amplitude both decrease with reduced fan speed *(see, e.g.,* **FIG. 13A****).** The first (fundamental) peak exhibits expected typical harmonic behavior repeating at octaves and fifths or 3/2 and double frequency. The amplitude of the dominant peak appears to be directly proportional to fan speed, exhibiting a linear relationship.

In some embodiments, the aperture plate **130** may be made from aluminum (or other like material) which helps to reduce the overall weight of the acoustic attenuation device **100** as well as makes creating the openings **134** in the aperture plate **130** *(e.g.,* via hand drilling) easier.

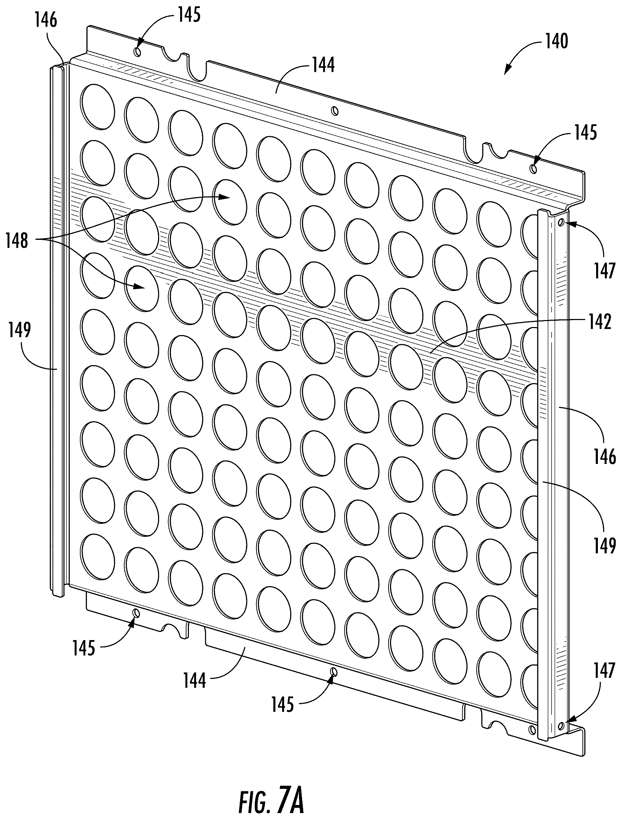

An example pressure plate **140** of the acoustic attenuation device **100** is illustrated in **FIGS. 7A-7C****.** As shown in **FIG. 1A, FIG. 1B****,** and **FIG. 2****,** according to embodiments of the present invention, the pressure plate **140** is sized and configured to engage with the housing **110** to hold and secure the volume matrix **120** and aperture plate **130** therebetween. The pressure plate **140** also provides a mounting location for the filter **150** *(see, e.g.,* **FIG. 2****,** **FIG. 8B,** and **FIG. 9B****).**

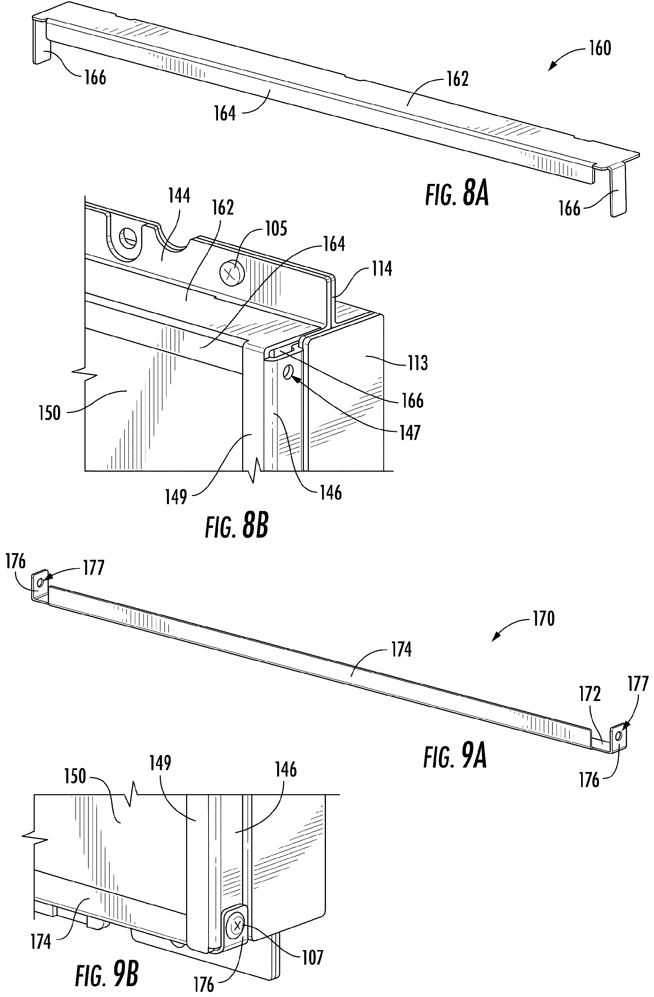

As shown in **FIGS. 7A-7B****,** in some embodiments, the pressure plate **140** has a main plate **142** comprising a plurality of openings **148.** The pressure plate **140** further comprises four walls **143, 146** extending outwardly from the main plate **142.** Two opposing walls **143** *(e.g.,* an upper and lower wall) extend outwardly from the main plate **142** in a first direction and are configured to engage with the housing **110** to secure the pressure plate **140** thereto. In some embodiments, the pressure plate **140** further comprises two flanged edges **144** extending outwardly from the upper and lower walls **143.** Similar to the flanged edges **144** of the side walls **113** of the housing **110**, the flanged edges **144** of the upper and lower walls **143** of the pressure plate **140** comprise a plurality of apertures **145** that are configured to receive a respective fastener **105** to secure the pressure plate **140** to the housing **110**, and thereby securing the volume matrix **120** and the aperture plate **130** therebetween *(see, e.g.,* **FIGS. 1B-1C** and **FIG. 8B****).** As the fasteners **105** are tightened, the pressure plate **140** and the housing **110** are pulled toward each other which applies pressure to the volume matrix **120** and aperture plate **130** sandwiched therebetween and the adhesive (or gasket) securing these components together, thereby creating a tight seal.

As further shown in **FIGS. 7A-7B****,** the other two opposing walls **146** *(e.g.,* side walls) extend outwardly from the main plate **142** in a second opposing direction. The opposing side walls **146** are configured to engage with and provide a mounting location for the filter **150.** In some embodiments, the two opposing side walls **146** may comprise one or more apertures **147.** In some embodiments, the apertures **147** in the side walls **146** are configured to receive a respective fastener **107** to secure the upper cap plate 160 and lower support plate **170** to the side walls **146** of the pressure plate **140** *(see, e.g.,* **FIG. 1B****,** **FIG. 8B,** and **FIG. 9B****).** In some embodiments, the opposing side walls **146** may further comprise a flanged edge or lip **149** extending inwardly therefrom. As described in further detail below, in addition to the upper cap plate **160** and lower support plate **170,** the flanged edges or lips **149** of the opposing side walls **146** of the pressure plate **140** may be configured to engage with outer edges of the filter **150** to hold and secure the filter **150** against the pressure plate **140** *(see, e.g.,* **FIG. 8B** and **FIG. 9B****).**

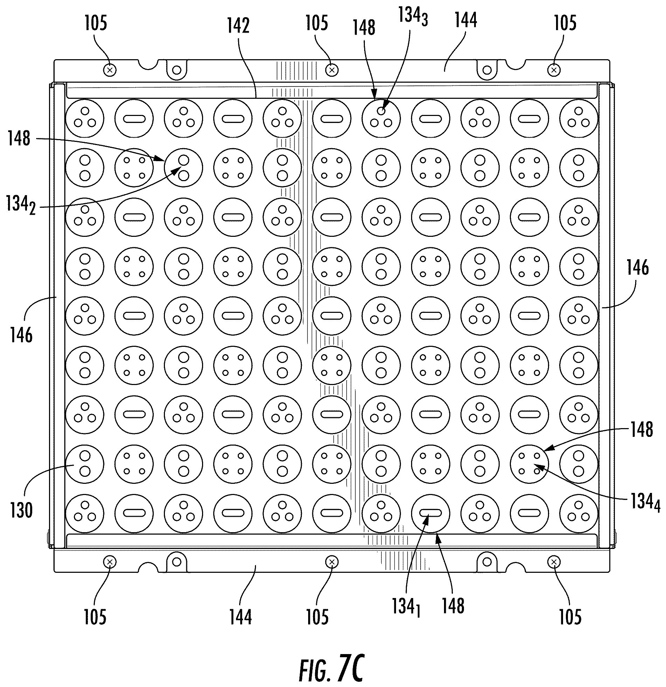

As shown in **FIG. 7C****,** each opening **148** in the pressure plate **140** is positioned to align with a respective opening arrangement **134₁, 134₂, 134₃, 134₄** in the aperture plate **130** (and corresponding chamber **126** in the volume matrix **120).** The openings **148** in the pressure plate **140** allow the resonant frequency created from the chambers **126** and openings **134** *(i.e.,* the attenuators) to enter into the interior cavity **215** of the telecommunications cabinet **200, 200',** thereby cancelling the noise emanating from the source (*i.e*., the cooling fans therein). It is further noted that while each opening **148** in the pressure plate **140** shown in **FIGS. 7A-7C** has a generally circular shape, the openings **148** may be formed in a variety of different shapes, for example, square or hexagonal.

Referring now to **FIGS. 8A-8B****,** the upper cap plate **160** of the acoustic attenuation device **100** according to embodiments of the present invention, is illustrated. As shown in **FIG. 8A****,** in some embodiments, the upper cap plate **160** may comprise a main body **162** having a flanged edge **164** extending longitudinally and downwardly therefrom. As further shown in **FIG. 8A****,** the upper cap plate **160** also comprises arm members **166** extending downwardly from opposing ends of the main body **162.** In some embodiments, each arm member **166** is configured to engage a corresponding side wall **146** of the pressure plate **140** *(see also* **FIG. 8B****).** As further shown in **FIG. 8B****,** the flanged edge **164** of the upper cap plate **160** is configured to overlap or engage with an outer edge of the filter **150** to help hold and secure the filter **150** against the pressure plate **140** (with the help of the flanged edges **149** of the opposing side walls **146** of the pressure plate **140).**

Referring now to **FIGS. 9A-9B****,** the lower support plate **170** of the acoustic attenuation device **100** according to embodiments of the present invention, is illustrated. In some embodiments, the lower support plate **170** is similar to the upper cap plate **160.** For example, as shown in **FIG. 9A****,** in some embodiments, the lower support plate **170** may comprise a main body **172** having a flanged edge **174** extending longitudinally and upwardly therefrom. As further shown in **FIG. 9A****,** the lower support plate **170** also comprises arm members **176** extending upwardly from opposing ends of the main body **172.** Each arm member **176** may comprise an aperture **177.** In some embodiments, the aperture **177** in each arm member **176** in the lower support plate **170** is configured to align with a respective aperture **147** in the corresponding side wall **146** of the pressure plate **140.** The aligned apertures **177, 147** are configured to receive a respective fastener **107** to secure the lower support plate **170** to the pressure plate **140** *(see also* **FIG. 9B****).** As further shown in **FIG. 9B****,** the flanged edge **174** of the lower support plate **170** is configured to engage with an outer edge of the filter **150** to help hold and secure the filter **150** against the pressure plate **140.** Thus, in some embodiments, the flanged edges **149** of the side walls **146** of the pressure plate **140,** the flanged edge **164** of the upper cap plate **160,** and the flanged edge **174** of the lower support plate **170** together define **a lip around** the outer edges of the filter **150** to help hold and secure the filter **150** to the acoustic **attenuation** device **100.**

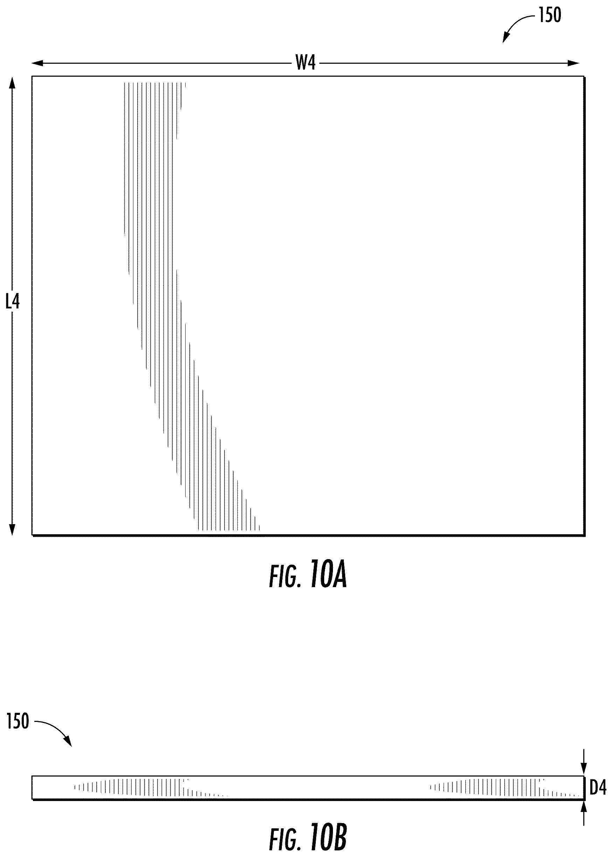

An example filter **150** of the acoustic attenuation device **100** is illustrated **in** **FIGS. 10A-10B**. As shown in **FIG. 1A****,** **FIG. 1C****,** and **FIG. 2****,** in some embodiments, **the filter 150** is sized and configured to fit between the opposing side walls **146** of the pressure **plate 140** and placed over the openings **148** in the pressure plate **140.** For example, in some embodiments, the filter **150** may have a length **(L4)** in a range of about 53.5 millimeters and about 667 millimeters, a width **(W4)** in a range of about 49.5 millimeters and about 663 millimeters, and a depth **(D4)** in a range of about 10 millimeters and about 30 millimeters. In some embodiments, the filter **150** comprises an open cell, acoustically transparent form (or like material). In some embodiments, the filter **150** is configured to act as an absorber to help increase the frequency bandwidth from each individual attenuator *(i.e.,* chamber **126** and opening arrangement **134).** In addition, the filter **150** helps to prevent particles (*e.g*., dirt or other debris) from becoming trapped inside the chambers **126,** which could vibrate and become an additional source of noise within the telecommunications cabinet **200, 200'.**

**FIGS. 11A-11E** and **FIGS. 12A-12B** illustrate the acoustic attenuation device **100** of the present invention installed in exemplary telecommunications cabinets **200, 200'** according to embodiments of the present invention. As shown in **FIGS. 11A-11E** and **FIG. 12A-12B****,** in general, the telecommunications cabinets **200**, **200'** are rectangular boxes having side walls **206,** a floor **202,** and a roof **204.** The telecommunications cabinets **200, 200'** further include one or more doors **210, 210'** hinged to the side walls **206.** Together these components define an internal cavity **215** in which electronics equipment **240** (*e.g*., servers) may be mounted therein.

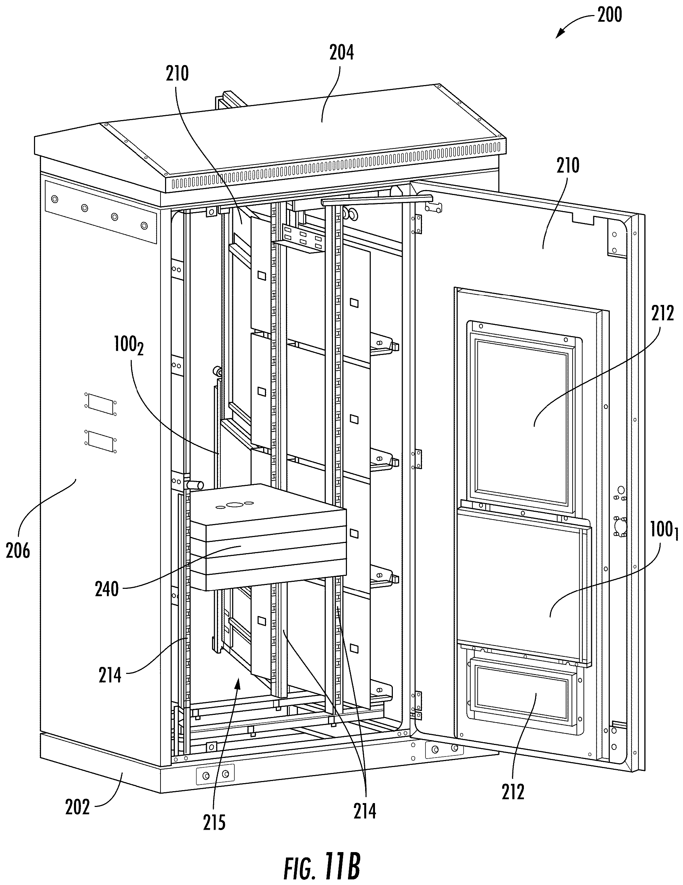

As shown in **FIGS. 11A-11D** and **FIG. 12A****,** in some embodiments, the acoustic attenuation device **100** may be mounted to an interior surface of the cabinet door **210, 210',** for example, adjacent to the one or more vents or filters **212, 212'** in the door **210, 210'.** As described above, and as shown in **FIG. 11B****,** the compact size of the acoustic attenuation device **100** of the present invention allows the device **100** to be positioned very close to the noise source *(i.e.,* the servers **240** on the equipment racks **214** within the cabinet **200, 200')** while occupying minimal space within the interior cavity **215, 215'** of the cabinet **200, 200'.**

Current cabinets **200, 200'** may use a negative pressure setup where the cooling fans **250, 250'** are housed in the roof void **220, 220'** and exhausted through vents **222, 222'** residing at the front and rear of the roof void **220**, **220'**. Accordingly, as shown in **FIG. 11E** and **FIG. 12B****,** in some embodiments, the acoustic attenuation device **100** may also be mounted proximate to the cooling fan **250, 250'** in the roof void **220, 220'** of the cabinet **200, 200'** to help mitigate the noise emanating therefrom. It is noted that the overall size of the acoustic attenuation device **100** may be scalable (e.g., dependent upon volume matrix **120** pattern described above) such that different shaped devices **100** could be installed in the internal cavities **215, 215'** and/or roof voids **220, 220'** of the cabinets **200, 200'**

The foregoing is illustrative of the present invention and is not to be construed as limiting thereof. Although a few exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. The invention is defined by the following claims, with equivalents of the claims to be included therein.

Further aspects of the disclosure may be summarized as follows:
1. An acoustic attenuation device adapted for use in a telecommunications cabinet, the device comprising:
   a housing comprising a cavity;
   a volume matrix sealed within the cavity of the housing, the volume matrix comprising a main body divided into a plurality of chambers;
   an aperture plate engaged with the volume matrix, the aperture plate comprising a plurality of opening arrangements, each opening arrangement aligned with a respective chamber of the volume matrix;
   a pressure plate coupled to the housing with the volume matrix and aperture plate secured therebetween, the pressure plate comprising a plurality of openings, each opening aligned with a respective opening arrangement in the aperture plate; and
   an acoustically transparent filter held against the pressure plate,
   wherein the pressure plate and the housing are configured to apply pressure to volume matrix and aperture plate sandwiched therebetween to create a tight seal, and
   wherein the opening arrangements of the aperture plate in combination with a corresponding chamber of the volume matrix create a plurality of attenuators configured to match one or more dominant frequencies of one or more cooling fans within the telecommunications cabinet such that the resonant frequency emanating from each attenuator have substantial phase inversion of the one or more dominant frequencies, thereby cancelling noise emanating from the telecommunications cabinet.
2. The acoustic attenuation device according to aspect 1, wherein at least one of the one or more cooling fans are part of a server, and wherein the device has compact size, thereby allowing the device to be fixed to an internal surface of the telecommunications cabinet in close proximity to server cooling fan while occupying minimal cabinet space.
3. The acoustic attenuation device according to any one of aspect 1 or aspect 2, further comprising an upper cap plate and a lower support plate, the upper cap plate and lower support plate configured to engage with the pressure plate to secure the filter in place.
4. The acoustic attenuation device according to any one of the preceding aspects, wherein the housing further comprises four side walls extending outwardly from a backing plate, the backing plate and side walls together define the cavity configured to receive and hold the volume matrix therein.
5. The acoustic attenuation device according to any one of the preceding aspects, in particular aspect 4, wherein the housing further comprises two flanged edges extending outwardly from opposing side walls, each flanged edge comprises a plurality of apertures configured to receive a respective fastener to secure the pressure plate thereto and/or to mount and secure the acoustic attenuation device to an interior surface of the telecommunications cabinet.
6. The acoustic attenuation device according to any one of the preceding aspects, wherein the plurality of chambers are arranged in a grid configuration in the main body of the volume matrix.
7. The acoustic attenuation device according to any one of the preceding aspects, wherein the plurality of chambers are arranged in a series of rows and columns in the main body of the volume matrix.
8. The acoustic attenuation device according to any one of the preceding aspects, wherein the volume matrix is formed from glass reinforced plastic and the aperture plate is formed from aluminum.
9. The acoustic attenuation device according to any one of the preceding aspects, wherein the plurality of opening arrangements of the aperture plate have openings comprising a single oblong opening, two circular openings in a stacked arrangement, three circular openings in a triangular arrangement, and/or four circular openings in a square arrangement, and wherein in the plurality of opening arrangements together achieve a resonant frequency needed to match the dominant frequencies of the cooling fans within the telecommunications cabinet.
10. The acoustic attenuation device according to any one of the preceding aspects, wherein the pressure plate further comprises an upper wall, a lower wall, and two opposing side walls extending outwardly from a main plate, the upper and lower walls extend outwardly from the main plate in a first direction and are configured to engage with the housing and the opposing side walls extend outwardly from the main plate in a second opposing direction and are configured to engage with and provide a mounting location for the filter.
11. The acoustic attenuation device according to any one of the preceding aspects, in particular aspect 10, wherein the pressure plate further comprises two flanged edges extending outwardly from the upper and lower walls, each flanged edge comprises a plurality of apertures configured to receive a respective fastener to secure the pressure plate to the housing, the fasteners are configured to pull the pressure plate and housing toward each other and apply pressure to the volume matrix and aperture plate sandwiched therebetween, thereby creating a tight seal.
12. The acoustic attenuation device according to any one of the preceding aspects, in particular aspect 10 or aspect 11, wherein the opposing side walls comprise one or more apertures configured to receive a respective fastener to secure the upper cap plate and/or lower support plate to the pressure plate.
13. The acoustic attenuation device according to any one of the preceding aspects, in particular aspects 10-12, wherein the opposing side walls further comprise a lip extending inwardly therefrom, and wherein the lip of each opposing side wall, the upper cap plate, and the lower support plate together are configured to hold and secure the filter against the pressure plate.
14. The acoustic attenuation device according to any one of the preceding aspects, in particular aspects 3-13, wherein the upper cap plate comprises a main body having a flanged edge extending longitudinally and downwardly therefrom and arm members extending downwardly from opposing ends of the main body, each arm member is configured to secure the upper cap plate to the pressure plate and the flanged edge configured to hold and secure the filter against the pressure plate.
15. The acoustic attenuation device according to any one of any one of the preceding aspects, in particular aspects 3-14, wherein the lower support plate comprises a main body having a flanged edge extending longitudinally and upwardly therefrom and arm members extending upwardly from opposing ends of the main body, each arm member is configured to secure the lower support plate to the pressure plate and the flanged edge is configured to hold and secure the filter against the pressure plate.
16. The acoustic attenuation device according to any one of the preceding aspects, wherein the filter comprises an open cell, acoustically transparent form.
17. The acoustic attenuation device according to any one of the preceding aspects, wherein the filter is configured to act as an absorber to help increase the frequency bandwidth from each individual attenuator.
18. An acoustic attenuation device adapted for use in a telecommunications cabinet, wherein the telecommunications cabinet contains at least one cooling fan having one or more dominant frequencies emanating therefrom, the acoustic attenuation device comprising:
   a housing comprising a cavity;
   a volume matrix sealed within the cavity of the housing, the volume matrix comprising a main body divided into a plurality of chambers arranged in a series of rows and columns;
   an aperture plate engaged with the volume matrix, the aperture plate comprising a plurality of opening arrangements, each opening arrangement aligned with a respective chamber of the volume matrix and together are configured to achieve a resonant frequency that match the one or more dominant frequencies of the at least one cooling fan within the telecommunications cabinet;
   a pressure plate coupled to the housing with the volume matrix and aperture plate secured therebetween, the pressure plate comprising a plurality of openings, each opening aligned with a respective opening arrangement in the aperture plate; and
   an acoustically transparent filter held against the pressure plate.
19. The acoustic attenuation device according to any one of the preceding aspects, in particular aspect 18, wherein the pressure plate and the housing are configured to apply pressure to volume matrix and aperture plate sandwiched therebetween to create a tight seal, and wherein the opening arrangements of the aperture plate in combination with the corresponding chamber of the volume matrix create a plurality of attenuators configured to match the one or more dominant frequencies of the at least one cooling fan such that the resonant frequency emanating from each attenuator have substantial phase inversion of the dominant frequencies, thereby cancelling noise emanating from the telecommunications cabinet.
20. The acoustic attenuation device according to any one of the preceding aspects, in particular aspect 18 or aspect 19, further comprising an upper cap plate and a lower support plate, the upper cap plate and lower support plate configured to engage with the pressure plate to secure the filter in place.
21. The acoustic attenuation device according to any one of the preceding aspects, in particular aspects 18-20, wherein the housing further comprises four side walls extending outwardly from a backing plate, the backing plate and side walls together define the cavity configured to receive and hold the volume matrix therein.
22. The acoustic attenuation device according to any one of the preceding aspects, in particular to any one of aspects 18-21, wherein the volume matrix is formed from glass reinforced plastic and the aperture plate is formed from aluminum.
23. The acoustic attenuation device according to any one of the preceding aspects, in particular aspects 18-22, wherein the plurality of opening arrangements of the aperture plate have openings comprising a single oblong opening, two circular openings in a stacked arrangement, three circular openings in a triangular arrangement, and/or four circular openings in a square arrangement, and wherein in the plurality of opening arrangements together achieve a resonant frequency needed to match the dominant frequencies of the cooling fans within the telecommunications cabinet.
24. The acoustic attenuation device according to any one of the preceding aspects, in particular aspects 18-23, wherein the pressure plate further comprises an upper wall, a lower wall, and two opposing side walls extending outwardly from a main plate, the upper and lower walls extend outwardly from the main plate in a first direction and are configured to engage with the housing and the opposing side walls extend outwardly from the main plate in a second opposing direction and are configured to engage with and provide a mounting location for the filter.
25. The acoustic attenuation device according any one of the preceding aspects, in particular aspect 24, wherein the opposing side walls comprise one or more apertures configured to receive a respective fastener to secure the upper cap plate and lower support plate to the pressure plate.
26. The acoustic attenuation device according to any one of the preceding aspects, in particular aspect 24 or aspect 25, wherein the opposing side walls further comprise a lip extending inwardly therefrom, and wherein the lip of each opposing side wall, the upper cap plate, and the lower support plate together are configured to hold and secure the filter against the pressure plate.
27. The acoustic attenuation device according to any one of the preceding aspects, in particular aspects 18-26, wherein the filter comprises an open cell, acoustically transparent form, and wherein the filter is configured to act as an absorber to help increase the frequency bandwidth from each individual attenuator.
28. A telecommunications cabinet, the cabinet comprising:
   a floor, a roof, a rear wall, opposing side walls, and a door which together define an internal cavity having one or more cooling fans therein; and
   at least one acoustic attenuation device mounted within the internal cavity,
   wherein the one or more cooling fans produce noise at one or more dominant frequencies, and wherein the acoustic attenuation device is configured to produce a resonant frequency that matches the one or more dominant frequencies of one or more cooling fans such that the resonant frequency emanating from the acoustic attenuation device has substantial phase inversion of the dominant frequencies, thereby cancelling noise emanating from the telecommunications cabinet.
29. The telecommunications cabinet according to any one of the preceding aspects, in particular aspect 28, wherein the at least one acoustic attenuation device is mounted to an interior surface of the door.
30. The telecommunications cabinet according to any one of the preceding aspects, in particular aspect 28 or aspect 29, wherein the at least one acoustic attenuation device is mounted within a void in the roof.
31. The telecommunications cabinet according to any one of the preceding aspects, in particular aspects 28-30, wherein the at least one acoustic attenuation device comprises:
   a housing comprising a cavity;
   a volume matrix sealed within the cavity of the housing, the volume matrix comprising a main body divided into a plurality of chambers;
   an aperture plate engaged with the volume matrix, the aperture plate comprising a plurality of opening arrangements, each opening arrangement aligned with a respective chamber of the volume matrix;
   a pressure plate coupled to the housing with the volume matrix and aperture plate secured therebetween, the pressure plate comprising a plurality of openings, each opening aligned with a respective opening arrangement in the aperture plate; and
   an acoustically transparent filter held against the pressure plate.
32. The telecommunications cabinet according to any one of the preceding aspects, in particular aspect 31, wherein the pressure plate and the housing of the acoustic attenuation device are configured to apply pressure to volume matrix and aperture plate sandwiched therebetween to create a tight seal, and wherein the opening arrangements of the aperture plate in combination with the corresponding chamber of the volume matrix create a plurality of attenuators configured to match the one or more dominant frequencies of one or more cooling fans within the telecommunications cabinet.
33. The telecommunications cabinet according to any one of the preceding aspects, in particular aspects 28-32, wherein at least one cooling fan resides within a void in the roof and at least one cooling fan is part of a server within the internal cavity, wherein an acoustic attenuation device is mounted in the void in the roof and an acoustic attenuation device is mounted to an interior surface of the door.

## Claims

1. An acoustic attenuation device adapted for use in a telecommunications cabinet, the device comprising:
a housing comprising a cavity;
a volume matrix sealed within the cavity of the housing, the volume matrix comprising a main body divided into a plurality of chambers;
an aperture plate engaged with the volume matrix, the aperture plate comprising a plurality of opening arrangements, each opening arrangement aligned with a respective chamber of the volume matrix;
a pressure plate coupled to the housing with the volume matrix and aperture plate secured therebetween, the pressure plate comprising a plurality of openings, each opening aligned with a respective opening arrangement in the aperture plate; and
an acoustically transparent filter held against the pressure plate,
wherein the pressure plate and the housing are configured to apply pressure to volume matrix and aperture plate sandwiched therebetween to create a tight seal, and
wherein the opening arrangements of the aperture plate in combination with a corresponding chamber of the volume matrix create a plurality of attenuators configured to match one or more dominant frequencies of one or more cooling fans within the telecommunications cabinet such that the resonant frequency emanating from each attenuator have substantial phase inversion of the one or more dominant frequencies, thereby cancelling noise emanating from the telecommunications cabinet.

2. The acoustic attenuation device according to Claim 1, wherein at least one of the one or more cooling fans are part of a server, and wherein the device has compact size, thereby allowing the device to be fixed to an internal surface of the telecommunications cabinet in close proximity to server cooling fan while occupying minimal cabinet space.

3. The acoustic attenuation device according to any one of Claim 1 or Claim 2, further comprising an upper cap plate and a lower support plate, the upper cap plate and lower support plate configured to engage with the pressure plate to secure the filter in place.

4. The acoustic attenuation device according to any one of the preceding claims, wherein the housing further comprises four side walls extending outwardly from a backing plate, the backing plate and side walls together define the cavity configured to receive and hold the volume matrix therein.

5. The acoustic attenuation device according to any one of the preceding claims, wherein the plurality of chambers are arranged in a grid configuration in the main body of the volume matrix.

6. The acoustic attenuation device according to any one of the preceding claims, wherein the plurality of chambers are arranged in a series of rows and columns in the main body of the volume matrix.

7. The acoustic attenuation device according to any one of the preceding claims, wherein the volume matrix is formed from glass reinforced plastic and the aperture plate is formed from aluminum.

8. The acoustic attenuation device according to any one of the preceding claims, wherein the plurality of opening arrangements of the aperture plate have openings comprising a single oblong opening, two circular openings in a stacked arrangement, three circular openings in a triangular arrangement, and/or four circular openings in a square arrangement, and wherein in the plurality of opening arrangements together achieve a resonant frequency needed to match the dominant frequencies of the cooling fans within the telecommunications cabinet.

9. The acoustic attenuation device according to any one of the preceding claims, wherein the pressure plate further comprises an upper wall, a lower wall, and two opposing side walls extending outwardly from a main plate, the upper and lower walls extend outwardly from the main plate in a first direction and are configured to engage with the housing and the opposing side walls extend outwardly from the main plate in a second opposing direction and are configured to engage with and provide a mounting location for the filter.

10. The acoustic attenuation device according to any one of the preceding claims, wherein the pressure plate further comprises two flanged edges extending outwardly from the upper and lower walls, each flanged edge comprises a plurality of apertures configured to receive a respective fastener to secure the pressure plate to the housing, the fasteners are configured to pull the pressure plate and housing toward each other and apply pressure to the volume matrix and aperture plate sandwiched therebetween, thereby creating a tight seal.

11. The acoustic attenuation device according to any one of Claim 9 or Claim 10, wherein the opposing side walls further comprise a lip extending inwardly therefrom, and wherein the lip of each opposing side wall, the upper cap plate, and the lower support plate together are configured to hold and secure the filter against the pressure plate.

12. The acoustic attenuation device according to any one of Claims 3-11, wherein the upper cap plate comprises a main body having a flanged edge extending longitudinally and downwardly therefrom and arm members extending downwardly from opposing ends of the main body, each arm member is configured to secure the upper cap plate to the pressure plate and the flanged edge configured to hold and secure the filter against the pressure plate.

13. The acoustic attenuation device according to any one of Claims 3-12, wherein the lower support plate comprises a main body having a flanged edge extending longitudinally and upwardly therefrom and arm members extending upwardly from opposing ends of the main body, each arm member is configured to secure the lower support plate to the pressure plate and the flanged edge is configured to hold and secure the filter against the pressure plate.

14. The acoustic attenuation device according to any one of the preceding claims, wherein the filter comprises an open cell, acoustically transparent form.

15. The acoustic attenuation device according to any one of the preceding claims, wherein the filter is configured to act as an absorber to help increase the frequency bandwidth from each individual attenuator.
